**Europäisches Patentamt**

(19) **European Patent Office**

**Office européen des brevets**

(11) Veröffentlichungsnummer: **0 007 645**
**B1**

(12) # EUROPÄISCHE PATENTSCHRIFT

(45) Veröffentlichungstag der Patentschrift:
15.07.81

(51) Int. Cl.³: **F 21 K 2/00, G 02 F 1/13**

(21) Anmeldenummer: **79102732.9**

(22) Anmeldetag: **31.07.79**

(54) **Vorrichtung zur Sammlung von Licht.**

(30) Priorität: **02.08.78 DE 2833926**

(43) Veröffentlichungstag der Anmeldung:
**06.02.80 Patentblatt 80/3**

(45) Bekanntmachung des Hinweises auf die Patenterteilung:
**15.07.81 Patentblatt 81/28**

(84) Benannte Vertragsstaaten:
**AT CH FR GB IT NL SE**

(56) Entgegenhaltungen:
DE-A-2 426 919
FR-A-2 404 347
GB-A-1 386 714
GB-A-2 003 290
US-A-4 058 639

ELEKTRONIK, Vol. 26, Nr. 6, Juni 1977,
W. GREUBEL et al.: «Fluoreszenz aktivierte Display
FLAD»,
Seiten 55–56

COMPUTER DESIGN, Vol 16, Nr. 10, Oktober 1977,
«Fluorescence-activated LCD5 may serve in low light
conditions»,
Seiten 34, 38

(73) Patentinhaber: **SIEMENS AKTIENGESELLSCHAFT Berlin
und München, Postfach 22 02 61, D-8000 München 22 (DE)**

(72) Erfinder: **Greubel, Waldemar, Dipl.-Phys.,
Johanneskirchnerstrasse 25, D-8000 München 81 (DE)**
Erfinder: **Quella, Ferdinand, Dr. Dipl.-Ing.,
Drygalski-Allee 118, D-8000 München 71 (DE)**

(56) Entgegenhaltungen:
ELECTRONICS, Vol. 50, Nr. 25, Dezember 1977,
M. BECHTLER et. al.: «Dim light is no turnoff for fluorescence activated LCD»,
Seiten 113–116

ELEKTROTECHNIK, Vol. 59, Nr. 11, Juni 1977
«Leuchtstark, farbig und kontrastreich»,
Seite 31

Vorrichtung zur Sammlung von Licht

Die Erfindung betrifft eine Vorrichtung gemäss dem Oberbegriff des Anspruchs 1. Ein solcher Kollektor ist bereits in mehreren Ausführungen bekannt und kann beispielsweise zum Einfangen von Sonnenenergie, [P.W. Mauer und G.T. Turechek, Research Disclosure, 29 (1975) 20, DE-A-26 20 115 oder A. Götzberger und W. Greubel, Appl. Phys. 14 (1977) 123], zur optischen Übertragung von Nachrichten (DE-A-27 42 899), zur Bildaufhellung passiver Displays [DE-A-25 54 226 oder W. Greubel und G. Baur, Electronik 6 (1977) 55] oder zur Erhöhung der Empfindlichkeit von Szintillatoren [G. Keil, Nucl. Instr. and Meth. 87 (1970) 111] verwendet werden.

Trifft Licht auf eine Fluoreszenzplatte, so wird der im Anregungsspektrum des Fluoreszenzstoffes liegende Anteil von den Fluoreszenzzentren absorbiert; der übrige Lichtanteil durchsetzt die Fluoreszenzplatte ungestört. Die absorbierte Strahlung wird – zu längeren Wellenlängen hin verschoben und räumlich ungerichtet – reemittiert. Von diesem Fluoreszenzlicht wird der weit überwiegende Teil durch (Total-)Reflexionen an den Plattengrenzflächen im Inneren der Trägerplatte fortgeleitet, bis er an bestimmten Auskoppelbereichen mit erhöhter Intensität austritt.

Die bisher mit Fluoreszenzplatten erzielten Wirkungsgrade bleiben noch immer deutlich hinter den theoretisch möglichen Werten zurück, und zwar vor allem deshalb, weil das Emissionsspektrum mit dem Absorptionsspektrum überlappt und daher die Fluoreszenzstrahlung der Platte eine endliche Absorptionslänge hat. Besonders unbefriedigend ist dabei, dass sich diese «Selbstabsorption» gerade bei Fluoreszenzkörpern mit grosser Sammelfläche besonders ungünstig auswirkt.

Man weiss bereits seit längerem, dass bei vielen organischen Fluoreszenzstoffen das Emissionsband gegenüber dem Anregungsband zu niedrigeren Frequenzen hin verschoben wird, wenn diese Farbstoffe in einer Flüssigkeit mit einer starken Orientierungspolarisation gelöst werden. Eine solche Rotverschiebung tritt auf, wenn das fluoreszierende Molekül in seinem Grund- und Anregungszustand verschiedene Dipolmomente hat und wenn sich die Umgebung, die während des Absorptionsprozesses unverändert bleibt, während der Existenz des Anregungszustandes umorientieren kann [E. Lippert, Z. Elektrochem. Ber. Bunsenges. phys. Chem. 61 (1957) 962].

Fluoreszenzkörper sollen jedoch nach Möglichkeit aus einem festen Trägermaterial bestehen. Denn feste Träger kann man, insbesondere wenn es organische Kunststoffe sind, mit relativ geringem Aufwand herstellen und verarbeiten, ein Vorzug, der insbesondere bei Massenfertigungen stark ins Gewicht fällt.

Dass auch in Festkörper-Lösungen die erwünschte Bandtrennung von der Dielektrizitätskonstants des Lösungsmittels abhängt und hierbei die Dipolunterschiede im Grund- und angeregten Zustand eine wichtige Rolle spielen, wird bereits in der zitierten Arbeit von Götzberger und Greubel erwähnt (vgl. den dortigen Abschnitt 3.3.). Weiterführende Untersuchungen der angedeuteten Zusammenhänge, denen sich entnehmen liesse, wie man Kunststoffe mit den erforderlichen Polarisationseigenschaften verwirklichen könnte, stehen allerdings noch aus. Vor allem aber fehlt es an Hinweisen, wie zu verfahren ist, damit die polaren Kunststoffe auch die an Fluoreszenzkörper zu stellenden Forderungen erfüllen. Ein Fluoreszenzkörper muss bekanntlich hochtransparent und thermisch wie fotochemisch stabil sein, sollte sich einfach in beliebige Formen bringen lassen, hat im Endzustand hart und formbeständig zu sein und sollte eine hohe Fluoreszenz-Quantenausbeute haben.

Aufgabe der vorliegenden Erfindung ist es, einen Fluoreszenzkörper anzugeben, der im Vergleich zu den bisher entwickelten Versionen eine deutlich geringere Selbstabsorption bei ansonsten ähnlich guten Eigenschaften hat. Diese Aufgabe wird erfindungsgemäss durch die im Patentanspruch 1 angegebene Vorrichtung gelöst.

In den vorgeschlagenen Trägersubstanzen, die sich durch eine ungewöhnlich hohe Lichtdurchlässigkeit und durch eine ausserordentlich starke Orientierungspolarisation auszeichnen, lassen sich die Fluoreszenzstoffe relativ bequem lösen. Die Einbettung von anorganischen Fluoreszenzstoffen gelingt ohne weiteres. Organische Fluoreszenzstoffe gehen dann in Lösung, wenn man noch eine geringe Menge einer amphiphilen Verbindung zusetzt.

Amphiphile Moleküle, also Moleküle mit einem hydrophilen (polaren) und einem lipophilen (unpolaren) Ende, assoziieren sich in nur hydrophilen oder nur lipophilen Flüssigkeiten zu charakteristischen, kugelförmigen Haufen, den sog. Mizellen. Die bekanntesten mizellären Lösungen sind wässrige Seifenlösungen, bei denen die einzelnen Seifen-Moleküle mit ihren polaren Enden dem Wasser zugewandt sind und mit ihren unpolaren Enden in das Innere der Mizelle weisen. Eine genauere Darstellung solcher speziellen Kolloid-Lösungen sind in Chem. Rev. 68 (1968) 1 oder in der am gleichen Tage eingereichten Patentanmeldung mit dem Titel «Vorrichtung zur Sammlung von Licht und Herstellungsverfahren für eine solche Vorrichtung» enthalten. Es hat sich herausgestellt, das amphiphile Substanzen bei Zugabe von Fluoreszenzstoffen spontan die einzelnen Fluoreszenzmoleküle mit einer Hülle umgeben und dass diese Mizellen auch in die erfindungsgemäss vorgesehenen Gläser eingebracht werden können. Es finden sich stets genügend polare Amphiphile, so dass auch bei Hinzunahme solcher Lösungsvermittler die Fluoreszenzzentren in ihrer unmittelbaren Umgebung eine hinreichend hohe Orientierungspolarisation mit ausreichend kurzer Relaxationszeit hervorrufen können.

Weitere vorteilhafte Ausgestaltungen und Weiterbildungen der Erfindung sind Gegenstand zusätzlicher Ansprüche.

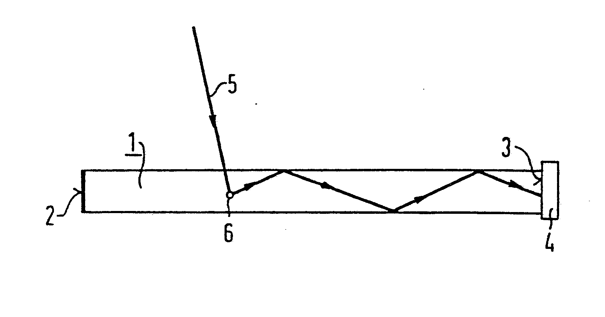

Der Lösungsvorschlag soll nun anhand eines Ausführungsbeispiels unter Bezugnahme auf die beigefügte Figur näher erläutert werden.

Die Figur zeigt in einem etwas schematisierten Seitenschnitt eine erfindungsgemässe Lichtsammelvorrichtung, die als Sonnenkollektor eingesetzt werden kann. Dieser Kollektor enthält im einzelnen eine Fluoreszenzplatte 1, die an drei ihrer vier Schmalseiten jeweils mit einer Reflexionsschicht 2 versehen ist und an ihrer vierten Schmalseite (Lichtaustrittsseite 3) eine Solarzelle 4 trägt. Die der Umgebung ausgesetzten Plattenseiten sind ausserdem mit einem transparenten Schutzfilm, beispielsweise einer Lackschicht überzogen. Der Film schützt das wasserlösliche Trägerglas vor der Umgebungsfeuchtigkeit und hindert zugleich das im Fluoreszenzkörper gebundene Glas daran, herauszudiffundieren.

In der Figur ist der typische Weg eines im Anregungsspektrum der fluoreszierenden Partikel liegenden Sonnenstrahls eingezeichnet: der mit 5 bezeichnete Strahl wird von einem Fluoreszenzzentrum 6 im Inneren der Fluoreszenzplatte 1 absorbiert, reemittiert und mittels Totalreflexionen an der Grenzfläche der Platte bzw. des Schutzfilms durch die Lichtaustrittsseite 3 auf die Solarzelle 4 geführt.

Das Trägerglas kann aus einem amorphen Polysilikat oder einem Polyphosphat bestehen. Geeignete Polysilikate sind Natrium- und Kalium-Wassergläser. Bei Verwendung eines Polyphosphats ist das Metall in der Regel ein- oder zweiwertig.

Der Fluoreszenzfarbstoff kann eine organische oder anorganische Verbindung sein. Geeignete organische Substanzen sind in den bereits eingangs zitierten Literaturstellen angegeben. Ein Beispiel für einen anorganischen Fluoreszenzstoff ist $UO_3$, das sich beispielsweise in Borsilikatglas einwandfrei lösen lässt.

Als amphiphiler Zusatz bieten sich die gewöhnlichen Seifen als die bekanntesten Vertreter an. Daneben sind aber auch andere polare Amphiphile denkbar, etwa polymere Seifen sowie Polyvinylpyrrolidon oder Polymethacrylsäure und deren Salze. Alle diese Verbindungen sind derart polar, dass sie um die einzelnen Fluoreszenzzentren – im Zusammenwirken mit dem hochpolaren Einbettungsmedium – die erforderliche Orientierungspolarisation schaffen. Ein weiteres, polares Lösungsmittel für die Fluoreszenzstoffe braucht also nicht hinzugefügt zu werden.

Es ist darauf hinzuweisen, dass die amphiphilen Zusätze nicht nur lösungsunterstützend wirken, sondern vielfach auch noch den Fluoreszenzstoff vor einer Zerstörung durch das teilweise recht aggressive Trägermedium schützen. So würden die meisten organischen Farbstoffe von Wasserglas, dessen $p_H$-Wert bei etwa 14 liegt, ohne die schützende Mizellenhülle rasch zersetzt werden.

Die Herstellung des vorgeschlagenen Fluoreszenzkörpers erfolgt am günstigsten mit folgender Schrittfolge: Zunächst erzeugt man nach üblichen Verfahren aus den Ausgangsstoffen flüssiges Trägerglas. In diese Masse wird dann der Fluoreszenzstoff – ggf. zusammen mit einem Amphiphil – eingemischt. Verwendet man eine amphiphile Substanz, so dürfen gewisse Temperaturen (ca. um 100 °C) nicht überschritten werden, da sonst die Mizellen zerfallen. Die Mischung wird in dünne Schichten gegossen und in bekannter Weise durch Trocknung verfestigt. Zur Herstellung von Polysilikaten bzw. -phosphaten wird auf die einschlägige Literatur verwiesen, beispielsweise auf das «Deutsche Apothekerbuch 6» zur Herstellung von Natrium-Wasserglas.

Die Erfindung ist nicht auf das dargestellte Ausführungsbeispiel beschränkt. Insbesondere kann der Fluoreszenzkörper auch anders als plattenartig gestaltet sein, wenn nur dafür gesorgt ist, dass er aufgrund von Totalreflexionen als Lichtfalle wirken kann. Eine Reihe von günstigen Körperformen sind in der DE-A-27 24 748 angegeben. Ferner sei darauf hingewiesen, dass der Begriff «Kolloid» im vorliegenden Zusammenhang nicht in seiner engen Definition verwendet wird, die bekanntlich bestimmte Teilchengrössen vorschreibt. Der gewählte Mizellendurchmesser hängt von einer Reihe von Randbedingungen ab und muss deutlich kleiner als eine Lichtwellenlänge sein, damit keine Lichtstreuung an den Mizellen erfolgt.

**Patentansprüche**

1. Vorrichtung zur Sammlung von Licht, mit einem als Lichtfalle wirkenden, vorzugsweise plattenförmig ausgebildeten Körper («Fluoreszenzkörper»), der aus einem festen Trägermaterial mit einem Brechungsindex grösser 1 besteht, fluoreszierende Partikel enthält und mindestens einem Lichtaustrittsfenster versehen ist, dadurch gekennzeichnet, dass die fluoreszierenden Partikel ein Dipolmoment mit unterschiedlichen Werten im Grund- bzw. Anregungszustand haben und dass das Trägermaterial ein polares, wasserhaltiges, amorphes Medium auf Polysilikat- oder Polyphosphat-Basis ist.

2. Vorrichtung nach Anspruch 1, dadurch gekennzeichnet, dass das Polysilikat aus Natrium- oder/und Kalium-Wasserglas besteht.

3. Vorrichtung nach Anspruch 1, dadurch gekennzeichnet, dass das Polyphosphat ein ein- oder zweiwertiges Metall, insbesondere Natrium oder Kalium enthält.

4. Vorrichtung nach einem der Ansprüche 1 bis 3, dadurch gekennzeichnet, dass in dem Trägermedium ein amphiphiler polarer Zusatz kolloidal gelöst ist, derart, dass die fluoreszierenden Partikel jeweils von einem der Kolloid-Teilchen umschlossen sind.

5. Vorrichtung nach Anspruch 4, dadurch gekennzeichnet, dass die fluoreszierenden Partikel aus einer organischen Verbindung bestehen.

6. Vorrichtung nach Anspruch 4 oder 5, dadurch gekennzeichnet, dass der amphiphile Zusatz eine Seife ist.

7. Vorrichtung nach einem der Ansprüche 1 bis 6, dadurch gekennzeichnet, dass der Fluoreszenzkörper mit einem transparenten Schutzüberzug versehen ist.

**Claims**

1. A device for collecting light which comprises a body ("fluorescence body") which acts as a light trap, which is preferably plate-shaped and which consists of a solid carrier material having a refractive index greater than 1, contains fluorescent particles and is provided with at least one light emergence window, characterised in that in the ground state and the excitation state respectively, the fluorescent particles have dipole moments of different value, and that the carrier material is a polar, hydrated, amorphous medium having a polysilicate or polyphosphate basis.

2. A device as claimed in Claim 1, characterised in that the polysilicate consists of sodium water glass and/or potassium water glass.

3. A device as claimed in Claim 1, characterised in that the polyphosphate contains a monovalent or bivalent metal, in particular, sodium or potassium.

4. A device as claimed in one of Claims 1 to 3, characterised in that an amphiphilic polar additive is colloidally dissolved in the carrier medium, in such a way that the fluorescent particles are each surrounded by one of the colloid particles.

5. A device as claimed in Claim 4, characterised in that the fluorescent particles consist of an organic compound.

6. A device as claimed in Claim 4 or Claim 5, characterised in that the amphiphilic additive is a soap.

7. A device as claimed in one of Claims 1 to 6, characterised in that the fluorescence body is provided with a transparent protective coating.

**Revendications**

1. Dispositif destiné à collecter de la lumière comprenant un corps («corps fluorescent»), servant de piège à lumière et ayant de préférence la forme d'une plaque, qui est en une substance support solide ayant un indice de réfraction supérieur à 1, qui renferme des particules fluorescentes et qui présente au moins une lucarne de sortie pour la lumière, caractérisé en ce que les particules fluorescentes ont un moment dipolaire de valeur différente à l'état fondamental et à l'état excité, et la substance support est un milieu amorphe, aqueux, polaire, à base de polysilicate de polyphosphate.

2. Dispositif suivant la revendication 1, caractérisé en ce que le polysilicate est du verre soluble au sodium ou/et au potassium.

3. Dispositif suivant la revendication 1, caractérisé en ce que le polyphosphate renferme un métal monovalent ou divalent, notamment du sodium ou du potassium.

4. Dispositif suivant l'une des revendications 1 à 3, caractérisé en ce que dans le milieu support est dissous colloïdalement un additif polaire amphiphile de manière à ce que les particules fluorescentes soient entourées respectivement par l'une des particules de colloïde.

5. Dispositif suivant la revendication 4, caractérisé en ce que les particules fluorescentes sont en un composé organique.

6. Dispositif suivant la revendication 4 ou 5, caractérisé en ce que l'additif amphiphile est un savon.

7. Dispositif suivant l'une des revendications 1 à 6, caractérisé en ce que le corps fluorescent est muni d'un revêtement transparent de protection.